# EUROPEAN PATENT APPLICATION

(11) **EP 4 528 409 A1**
(43) Date of publication of application: **26.03.2025**
(21) Application number: 24192961.1
(22) Date of filing: 05.08.2024
(51) Int. Cl.: G05B 19/4068, G05B 19/409, G05B 19/418

(54) **DISPLAY PROCESSING APPARATUS, SUBSTRATE PROCESSING APPARATUS, DISPLAY METHOD, SUBSTRATE PROCESSING METHOD, METHOD OF MANUFACTURING SEMICONDUCTOR DEVICE AND PROGRAM**

(30) Priority: 31.08.2023 JP 2023141838
(71) Applicant: Kokusai Electric Corp., Tokyo 1010045 (JP)
(72) Inventor: MORI, Shinichiro, Toyama-shi, 939-2393 (JP)
(74) Representative: Verscht, Thomas Kurt Albert

(57) **Abstract**

There is provided a technique capable of easily identifying information related to a valid setting item used in a substrate processing apparatus when performing a file editing in a display processing apparatus. There is provided a technique that includes: a memory configured to store a file containing a plurality of items for each of a plurality of categories, setting values for each of the plurality of items and validity information indicating whether the setting values for each of the plurality of items are valid, wherein process conditions for a substrate are classified into the plurality of categories; a display configured to display the validity information and the setting values for each of the plurality of items classified for each of the plurality of categories on a screen for each of the categories; and a manipulator configured to perform an edit operation on the validity information displayed on the screen.

## Description

### [Technical Field]

The present disclosure relates to a display processing apparatus, a substrate processing apparatus, a display method, a substrate processing method, a method of manufacturing a semiconductor device and a program.

### [Related Art]

According to some related arts, a technique capable of clarifying whether or not there is a change to a setting item when editing a file such as a recipe may be used.

### [Related Art Document]

### [Patent Document]

Patent Document 1: Japanese Patent Laid-Open No. 2001-189248

### [Disclosure]

### [Technical Problem]

According to the present disclosure, there is provided a technique capable of easily identifying information related to a valid setting item used in a substrate processing apparatus when performing a file editing operation in a display processing apparatus.

### [Technical Solution]

According to an embodiment of the present disclosure, there is provided a technique that includes a memory configured to store a file containing a plurality of items for each of a plurality of categories, setting values for each of the plurality of items and validity information indicating whether the setting values for each of the plurality of items are valid, wherein process conditions for a substrate are classified into the plurality of categories; a display configured to display the validity information and the setting values for each of the plurality of items classified for each of the plurality of categories on a screen for each of the categories; and a manipulator configured to perform an edit operation on the validity information displayed on the screen.

### [Advantageous Effects]

According to some embodiments of the present disclosure, it is possible to easily identify information related to a valid setting item used in a substrate processing apparatus when performing a file editing operation in a display processing apparatus.

### [Brief Description of Drawings]

FIG. 1 is a diagram schematically illustrating a perspective view of a substrate processing apparatus according to one or more embodiments of the present disclosure.
FIG. 2 is a diagram schematically illustrating a cross-section of the substrate processing apparatus according to the embodiments of the present disclosure, when viewed from side.
FIG. 3 is a block diagram schematically illustrating exemplary configurations of the substrate processing apparatus and a display processing apparatus according to the embodiments of the present disclosure.
FIG. 4 is a block diagram schematically illustrating exemplary configurations of a process controller and a transfer controller of the substrate processing apparatus according to the embodiments of the present disclosure.
FIG. 5 is a diagram schematically illustrating an example of a screen of the display processing apparatus according to the embodiments of the present disclosure.
FIG. 6 is a diagram schematically illustrating an example of a file structure according to the embodiments of the present disclosure, wherein group information of the file structure is shown.
FIG. 7 is a diagram schematically illustrating an example of the file structure according to the embodiments of the present disclosure, wherein item information of the file structure is shown.
FIG. 8 is a diagram schematically illustrating a flowchart of a file editing process according to the embodiments of the present disclosure.
FIG. 9 is a diagram schematically illustrating a transition of screens on the display processing apparatus according to the embodiments of the present disclosure.
FIG. 10 is a diagram schematically illustrating a flowchart of a processing performed by the substrate processing apparatus according to the embodiments of the present disclosure.

### [Detailed Description]

### <Embodiments of Present Disclosure>

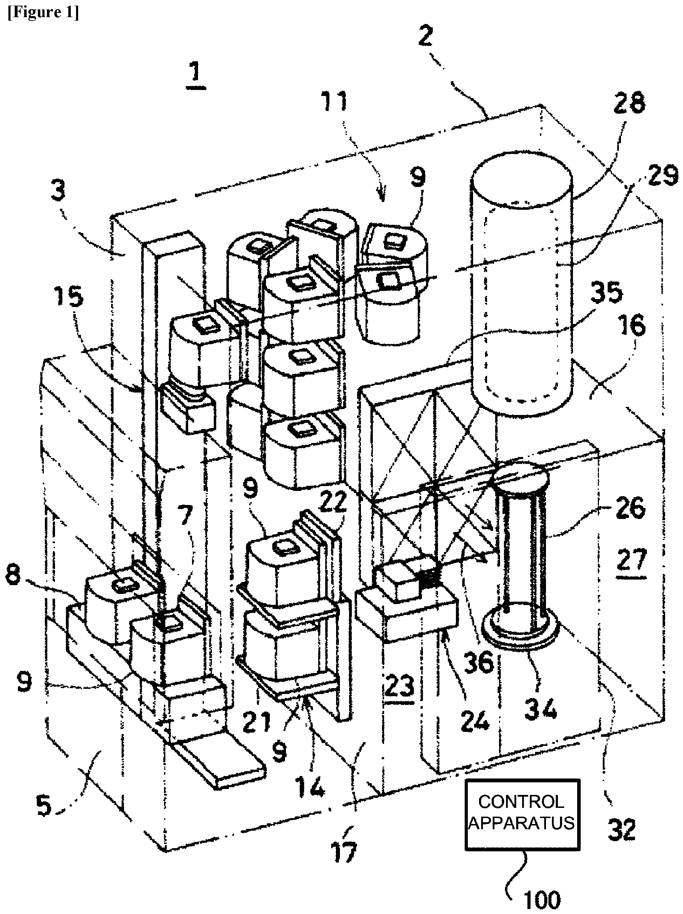

Hereinafter, one or more embodiments (also simply referred to as "embodiments") of the technique of the present disclosure will be described in detail mainly with reference to FIGS. 1 to 10. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. Further, the technique of the present disclosure is not limited to the embodiments described below. That is, the technique of the present disclosure may be modified in various ways without departing from the scope thereof.

Further, process conditions for a substrate (such as a command to a substrate processing apparatus, setting information for various items and their combination with parameters) may be recorded in a "file". In the following description, for example, the file refers to a "recipe file" or refers to a "parameter file".

Further, in the following description, an operator refers to a person who uses the substrate processing apparatus or a person who processes the substrate using the substrate processing apparatus.

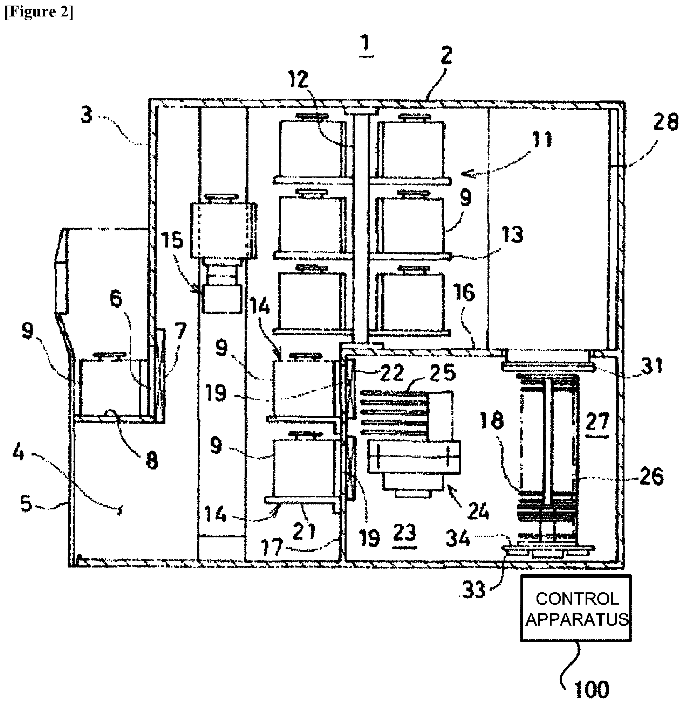

First, with reference to FIGS. 1 and 2, an outline of a substrate processing apparatus 1 according to the present embodiments will be described.

FIG. 1 is a diagram schematically illustrating a perspective view of an example of the substrate processing apparatus 1 according to the present embodiments, and FIG. 2 is a diagram schematically illustrating a cross-section of the substrate processing apparatus 1 according to the present embodiments when viewed from side. In FIGS. 1 and 2, a vertical type substrate processing apparatus is shown as an example of the substrate processing apparatus 1, and a semiconductor wafer made of a material such as silicon is shown as an example of the substrate (that is, a wafer 18) to be processed in the substrate processing apparatus 1.

As shown in FIGS. 1 and 2, the substrate processing apparatus 1 includes a housing 2. A front maintenance port 4 serving as an opening provided for maintenance is provided at a lower portion of a front wall 3 of the housing 2. The front maintenance port 4 may be opened or closed by a front maintenance door 5.

A pod loading/unloading port 6 is provided at the front wall 3 of the housing 2 so as to communicate with an inside and an outside of the housing 2. The pod loading/unloading port 6 may be opened or closed by a front shutter (which is a pod loading/unloading port opening/closing structure) 7. A loading port (which is a loading port shelf, that is, a transfer table for a substrate transfer container) 8 is provided in front of the pod loading/unloading port 6. The loading port 8 is configured such that a pod 9 is aligned while placed on the loading port 8.

For example, the pod 9 is configured as a sealed type substrate transfer container. The pod 9 may be transferred (loaded) into and placed on the loading port 8 by an in-process transfer apparatus (not shown) and may be transferred (unloaded) out of the loading port 8 by the in-process transfer apparatus.

A rotatable pod shelf (which is a storage shelf for the substrate transfer container) 11 is provided in the housing 2 to be located over a substantially center portion of the housing 2 in a front-rear direction. The rotatable pod shelf 11 is configured such that a plurality of pods including the pod 9 can be stored (or placed) on the rotatable pod shelf 11. Hereinafter, the plurality of pods including the pod 9 may also be simply referred to as "pods 9".

The rotatable pod shelf 11 includes: a vertical support column 12 capable of rotating intermittently and a plurality of shelf plates (which are placement shelves for the substrate transfer container) 13. The plurality of shelf plates 13 are configured to be supported (or fixed) radially by the vertical support column 12 at positions of an upper portion, a mid portion and a lower portion of the vertical support column 12. Each of the plurality of shelf plates 13 is configured to accommodate at least one of the pods 9.

A pod opener (which is a structure capable of opening and closing a lid of the substrate transfer container) 14 is provided below the rotatable pod shelf 11. The pod opener 14 is provided with a configuration on which the pod 9 is placed and capable of opening and closing a lid of the pod 9.

A pod transfer structure (which is a container transfer structure) 15 is provided among the loading port 8, the rotatable pod shelf 11 and the pod opener 14. The pod transfer structure 15 is configured such that the pod 9 can be elevated and lowered and can be moved forward and backward in a horizontal direction while being supported by the pod transfer structure 15. The pod transfer structure 15 is further configured such that the pod 9 can be transferred among the loading port 8, the rotatable pod shelf 11 and the pod opener 14.

A sub-housing 16 is provided below the substantially center portion of the housing 2 in the front-rear direction to extend toward a rear end of the substrate processing apparatus 1. A pair of wafer loading/unloading ports (substrate loading/unloading ports) 19 through which the wafer 18 serving as the substrate is loaded into or unloaded out of the sub-housing 16 is provided at a front wall 17 of the sub-housing 16. The pair of wafer loading/unloading ports 19 is arranged vertically in two stages. A pair of pod openers (including the pod opener 14) is provided at the pair of wafer loading/unloading ports 19, respectively. For example, an upper pod opener and a lower pod opener may be provided as the pair of pod openers. The upper pod opener and the lower pod opener may be collectively or individually referred to as the "pod opener 14".

The pod opener 14 may include: a placement table 21 where the pod 9 is placed thereon; and an attaching/detaching structure 22 capable of attaching and detaching the lid of the pod 9. The pod opener 14 is configured such that a wafer entrance of the pod 9 is opened or closed by detaching or attaching the lid of the pod 9 placed on the placement table 21 by the attaching/detaching structure 22.

The sub-housing 16 defines a transfer chamber 23 fluidically isolated from a space (hereinafter, also referred to as a "pod transfer space") in which the pod transfer structure 15 or the rotatable pod shelf 11 is provided. A wafer transfer structure (which is a substrate transfer structure) 24 is provided at a front region of the transfer chamber 23. The wafer transfer structure 24 may include a predetermined number of wafer placement plates (for example, as shown in FIG. 2, five wafer placement plates) 25 on which a predetermined number of wafers including the wafer 18 are placed. Each of the wafer placement plates 25 can be moved directly in the horizontal direction, can be rotated in the horizontal direction and can be elevated or lowered in a vertical direction. The wafer transfer structure 24 is configured such that the wafer 18 can be loaded into or unloaded out of a boat (which is a substrate retainer) 26.

In a rear region of the transfer chamber 23, a standby space 27 where the boat 26 is accommodated and in standby is provided, and a process furnace 28 such as a vertical type process furnace is provided above the standby space 27. A process chamber 29 is provided inside the process furnace 28, and a lower end portion of the process chamber 29 is configured as a furnace opening. The furnace opening is opened or closed by a furnace opening shutter (which is a furnace opening opening/closing structure) 31. The process chamber 29 serves as an example of a process vessel in which the substrate (that is, the wafer 18) is processed.

A boat elevator (which is a substrate retainer elevating structure) 32 capable of elevating and lowering the boat 26 is provided between a right end of the housing 2 and a right end of the standby space 27 of the sub-housing 16. A seal cap 34 serving as a lid is horizontally attached to an arm 33 connected to an elevating platform of the boat elevator 32. The seal cap 34 is configured such that the boat 26 can be vertically supported by the seal cap 34, and such that the furnace opening can be airtightly closed by the seal cap 34 while the boat 26 is loaded into the process chamber 29.

The boat 26 is configured such that a plurality of wafers (for example, from 50 wafers to 125 wafers) including the wafer 18 are supported on the boat 26 in a horizontal orientation in a multistage manner with their centers aligned with one another. Hereinafter, the plurality of wafers including the wafer 18 may also be simply referred to as "wafers 18". Further, in the present specification, a notation of a numerical range such as "from 50 wafers to 125 wafers" means that a lower limit and an upper limit are contained in the numerical range. Therefore, for example, a numerical range "from 50 wafers to 125 wafers" means a range equal to or higher than 50 wafers and equal to or less than 125 wafers. The same also applies to other numerical ranges described in the present specification.

A clean air supplier (which is a clean air supply structure or a clean air supply system) 35 is arranged at a position facing the boat elevator 32. The clean air supplier 35 is constituted by a supply fan and a dustproof filter so as to supply clean air 36 such as an inert gas and a clean atmosphere. As the inert gas, for example, a nitrogen (N)-containing gas may be used. As the nitrogen-containing gas, for example, a gas such as nitrogen (N₂) gas and ammonia (NH₃) gas may be used. As the nitrogen-containing gas, for example, one or more of the gases exemplified above may be used. A notch alignment device (not shown) serving as a substrate alignment device configured to align a circumferential position of the wafer 18 is provided between the wafer transfer structure 24 and the clean air supplier 35.

The clean air 36 ejected from the clean air supplier 35 is circulated in components such as the notch alignment device (not shown), the wafer transfer structure 24 and the boat 26. Thereafter, the clean air 36 is exhausted out of the housing 2 through a duct (not shown), or is ejected again into the transfer chamber 23 by the clean air supplier 35.

Subsequently, an operation of the substrate processing apparatus 1 will be described.

When the pod 9 is supplied to the loading port 8, the pod loading/unloading port 6 is opened by the front shutter 7. Then, the pod 9 placed on the loading port 8 is transferred (loaded) into the housing 2 through the pod loading/unloading port 6 by the pod transfer structure 15, and is placed on a designated shelf plate among the plurality of shelf plates 13 of the rotatable pod shelf 11. The pod 9 is temporarily stored in the rotatable pod shelf 11. Then, the pod 9 is transferred from the designated shelf plate among the plurality of shelf plates 13 to the placement table 21 of the pod opener 14 (that is, one of the upper pod opener and the lower pod opener) by the pod transfer structure 15. Alternatively, the pod 9 may be transferred directly from the loading port 8 to the placement table 21 of the pod opener 14.

When the pod 9 is being transferred, the wafer loading/unloading ports 19 are closed by the attaching/detaching structure 22, and the transfer chamber 23 is filled with the clean air 36. For example, the transfer chamber 23 is filled with the nitrogen-containing gas serving as the clean air 36 such that an oxygen concentration in the transfer chamber 23 is set to 20 ppm or less, for example, which is much lower than an oxygen concentration in the housing 2 (which is under an atmospheric atmosphere).

When an end surface of the pod 9 placed on the placement table 21 is pressed against an opening edge of one of the pair of wafer loading/unloading ports 19 of the front wall 17 of the sub-housing 16, the attaching/detaching structure 22 detaches the lid of the pod 9 and the wafer entrance of the pod 9 is opened.

When the pod 9 is opened by the pod opener 14 (that is, one of the upper pod opener and the lower pod opener), the wafer 18 is then taken out from the pod 9 by the wafer transfer structure 24, transferred to the notch alignment device (not shown), and aligned by the notch alignment device. Then, by the wafer transfer structure 24, the wafer 18 is transferred (or loaded) into the standby space 27 provided in the rear region of the transfer chamber 23, and loaded (or charged) into the boat 26.

After the wafer 18 is charged into the boat 26, the wafer transfer structure 24 then returns to the pod 9 and transfers a next wafer among the wafers 18 from the pod 9 into the boat 26.

While the wafer transfer structure 24 loads the wafers 18 into the boat 26 through the pod opener 14 (which is one of the upper pod opener and the lower pod opener), another pod 9 is transferred from the rotatable pod shelf 11 by the pod transfer structure 15 to the pod opener 14 (which is the other one of the upper pod opener and the lower pod opener), and the lid of the aforementioned another pod 9 is opened by the other one of the upper pod opener and the lower pod opener.

When a predetermined number of wafers including the wafer 18 are charged into the boat 26, the furnace opening of the process furnace 28 closed by the furnace opening shutter 31 is opened by the furnace opening shutter 31. Subsequently, the boat 26 accommodating the wafers 18 is elevated by the boat elevator 32 such that the boat 26 is loaded (inserted) into the process chamber 29.

After the boat 26 is loaded, the furnace opening is airtightly closed by the seal cap 34. Further, according to the present embodiments, at this timing (that is, after the boat 26 is loaded), a purge step (also referred to as a "pre-purge step") of replacing an inner atmosphere of the process chamber 29 with the inert gas is performed.

The process chamber 29 is vacuum-exhausted by a gas exhaust structure (which is a gas exhauster) (not shown) such that an inner pressure of the process chamber 29 reaches and is maintained at a desired pressure (vacuum degree). Further, the process chamber 29 is heated to a predetermined temperature by a heater driver (not shown) such that a desired temperature distribution of the process chamber 29 is obtained.

Further, a process gas whose flow rate is controlled to a predetermined flow rate is supplied by a gas supply structure (which is a gas supplier) (not shown), and the process gas comes into contact with a surface of the wafer 18 while flowing through the process chamber 29. Thereby, a predetermined processing such as a substrate processing described later is performed on the surface of the wafer 18. Further, the process gas after a reaction of the predetermined processing is exhausted from the process chamber 29 by the gas exhaust structure. In the present specification, the "process gas" refers to a gas supplied into the process chamber 29. The same also applies to the following description.

After a predetermined process time has elapsed, the inert gas is supplied from an inert gas supply source (not shown) by the gas supply structure, the inner atmosphere of the process chamber 29 is replaced with the inert gas, and the inner pressure of the process chamber 29 is returned to the normal pressure (after-purge step). Then, the boat 26 is lowered by the boat elevator 32 through the seal cap 34. In the present specification, the "process time" refers to a time duration of continuously performing a process related thereto. The same also applies to the following description.

After the wafer 18 is processed, the wafer 18 and the pod 9 are transferred (unloaded) out of the housing 2 in an order reverse to that of loading the wafer 18 and the pod 9 into the housing 2 described above. Then, an unprocessed wafer 18 is further loaded into the boat 26, and a batch processing for the wafer 18 is repeatedly performed.

According to the present embodiments, as shown in FIGS. 1 and 2, the substrate processing apparatus 1 includes a control apparatus (which is a control apparatus) 100, and the control apparatus 100 is configured to control the substrate processing apparatus 1. The control apparatus 100 may be provided (embedded) in the substrate processing apparatus 1, or may be provided outside the substrate processing apparatus 1 in a manner accessible thereto. In the following, a case where the control apparatus 100 according to the present embodiments is applied to the substrate processing apparatus 1 will be described. However, the control apparatus 100 may control an apparatus other than the substrate processing apparatus 1.

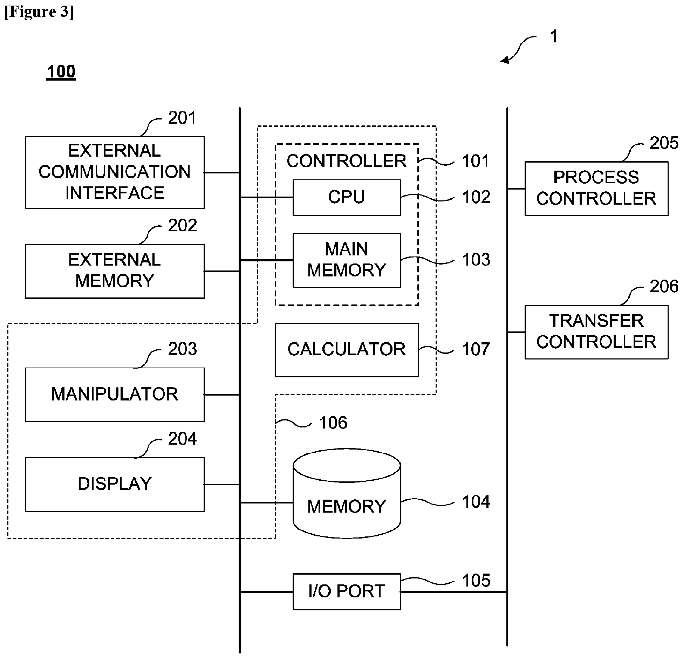

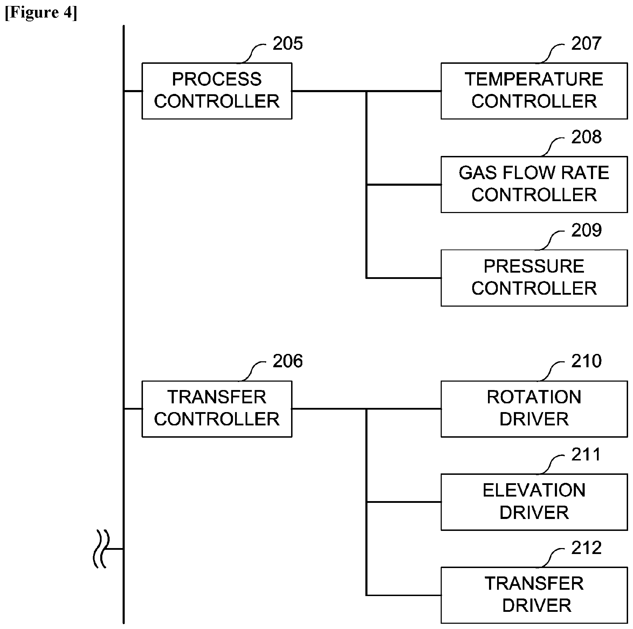

Subsequently, with reference to FIGS. 3 and 4, a configuration of a control system of the substrate processing apparatus 1 according to the present embodiments will be described. FIGS. 3 and 4 are block diagrams schematically illustrating an example of a functional configuration of the substrate processing apparatus 1 according to the present embodiments.

As shown in FIG. 3, the substrate processing apparatus 1 includes the control apparatus (which is a main controller) 100, an external communication interface 201, an external memory 202, a manipulator 203, a display (which is a display structure) 204, a process controller 205 and a transfer controller 206.

Further, the control apparatus 100 is configured as a computer including a CPU (Central Processing Unit) 102, a main memory 103 such as a RAM (Random Access Memory), a memory 104 and an I/O interface (also referred to as an "I/O port") 105. In the memory 104, a recipe file such as a recipe in which process conditions and process sequences of the substrate processing are defined, a control program file (such as a recipe execution program) for executing the recipe file, a parameter file (setting value file) in which parameters for setting the process conditions and the process sequences are defined, an error processing program file, a parameter file for an error processing, various screen files including an input screen to be used to input process parameters and various icon files and the like (which are not shown) are stored (or saved). For example, the control apparatus 100 is electrically connected to a network such as the Internet, a LAN (Local Area Network) and a WAN (Wide Area Network) by using the external communication interface 201, and is configured to be capable of communicating with external apparatuses via the network.

The control apparatus 100 is connected to the process controller 205 and the transfer controller 206 via the I/O port 105. Since the control apparatus 100 is electrically connected to each of the process controller 205 and the transfer controller 206 via the I/O port 105, for example, each piece of data can be transmitted or received and each file can be downloaded or uploaded between the control apparatus 100 and each of the process controller 205 and the transfer controller 206.

The control apparatus 100 is connected to an external host computer (not shown) via the external communication interface 201. Therefore, even when the substrate processing apparatus 1 is installed in a clean room, the host computer can be disposed at a location such as an office outside the clean room. In addition, the external memory 202 (which serves as a mounting structure on which a recording medium such as a USB (Universal Serial Bus) memory is installed or removed) is connected to the control apparatus 100.

The display 204 is a display structure (not shown) such as a liquid crystal display panel, which displays a screen. Further, the manipulator 203 performs an input operation using an input device (not shown) such as a keyboard configured to input an operation input. In addition, when a touch panel is used, for example, the manipulator 203 and the display 204 may be configured as an integrated structure.

The display 204 displays the screen to be used to check a state of a substrate process system controlled by the process controller 205 and a state of a substrate transfer system controlled by the transfer controller 206. Further, the display 204 can display, on the screen, various operation buttons serving as an input interface through which an operation instruction can be input to the substrate process system and the substrate transfer system.

For example, the display 204 can display the screen to be used to edit a setting value (which is contained in the recipe file in which the process conditions of the substrate processing of a display processing apparatus 106 according to the present embodiments are defined) and validity information (which indicates whether the item related to the setting value is valid or invalid and is contained in the recipe file). The display processing apparatus 106 will be described in detail later.

As shown in FIG. 4, the process controller 205 may include at least one selected from the group of a temperature controller 207, a gas flow rate controller 208 and a pressure controller 209. Each of the temperature controller 207, the gas flow rate controller 208 and the pressure controller 209 constitutes a sub-controller, and is electrically connected to the process controller 205. Thereby, for example, each piece of data can be transmitted or received and each file can be downloaded or uploaded between the process controller 205 and each sub-controller (that is, the temperature controller 207, the gas flow rate controller 208 and the pressure controller 209). The process controller 205 and each sub-controller (that is, the temperature controller 207, the gas flow rate controller 208 and the pressure controller 209) may be configured separately or integrally.

As shown in FIG. 4, the transfer controller 206 is configured to control each of a rotation driver 210, an elevation driver 211 and a transfer driver 212. The rotation driver 210, the elevation driver 211 and the transfer driver 212 constitutes a drive system of the substrate processing apparatus 1. For example, the transfer controller 206 is configured to control the rotatable pod shelf 11 by the rotation driver 210, to control the boat elevator 32 by the elevation driver 211 and to control transfer operations of the pod transfer structure 15, the wafer transfer structure 24 and the boat 26 by the transfer driver 212.

According to the present embodiments, each of the control apparatus 100, the process controller 205 and the transfer controller 206 may be embodied by a general computer system instead of a dedicated computer system. For example, by installing in the general computer system a program for executing the predetermined processing described above from a predetermined recording medium such as a CD-ROM and a USB memory storing the program, each controller described above may be provided to perform the predetermined processing.

Further, a method of supplying the program can be appropriately selected. Instead of or in addition to being supplied through the predetermined recording medium as described above, for example, the program may be provided through a communication network.

The recipe file such as the recipe in which the process conditions of the substrate processing are defined may be obtained from another apparatus via the external communication interface 201, or may be obtained from a recording medium such as a USB via the external memory 202.

Further, for example, the memory 104 is configured as an auxiliary memory such as a hard disk drive (HDD), a solid state drive (SSD) and a flash memory. In the memory 104, a recording medium in which an operation program executed by the CPU 102 is recorded or a recording medium in which the recipe file is recorded may be stored. The operation program stored in the memory 104 is transferred to the main memory 103 of a controller 101 and executed when a substrate manufacturing apparatus such as the substrate processing apparatus 1 is started up, for example.

Further, in the memory 104, a display processing program for executing a display process according to the present embodiments is stored. For example, the display processing program is installed in advance in the substrate processing apparatus 1. Thereby, the substrate processing apparatus 1 functions as the display processing apparatus 106 according to the present embodiments. The display processing program may be implemented by appropriately installing the display processing program (which may be recorded on a non-volatile recording medium or distributed via a network) in the substrate processing apparatus 1. For example, as the non-volatile recording medium, a component such as a CD-ROM, a magneto-optical disk, a HDD, a DVD-ROM, a flash memory, a memory card and a USB may be used.

In addition, for example, the display processing apparatus 106 according to the present embodiments is constituted by the CPU 102, the main memory 103, a calculator (which is a tally structure) 107, the manipulator 203 and the display 204, and performs display processing by the CPU 102 executing the display processing program located on the main memory 103 when the control apparatus 100 is started up. Further, the display processing apparatus 106 may further include the memory 104.

As described above, the display 204 displays the screen able to be used to edit the setting value (which is contained in the recipe file in which the process conditions of the substrate processing are defined) and the validity information (which is contained in the recipe file). On the screen, the process conditions of the substrate processing are classified into a plurality of categories. Further, on the screen, a plurality of items contained in each category and the validity information and the setting value for each item are displayed. In addition, the display 204 may also function as the manipulator 203 by providing operation buttons through which the validity information and the setting value can be edited.

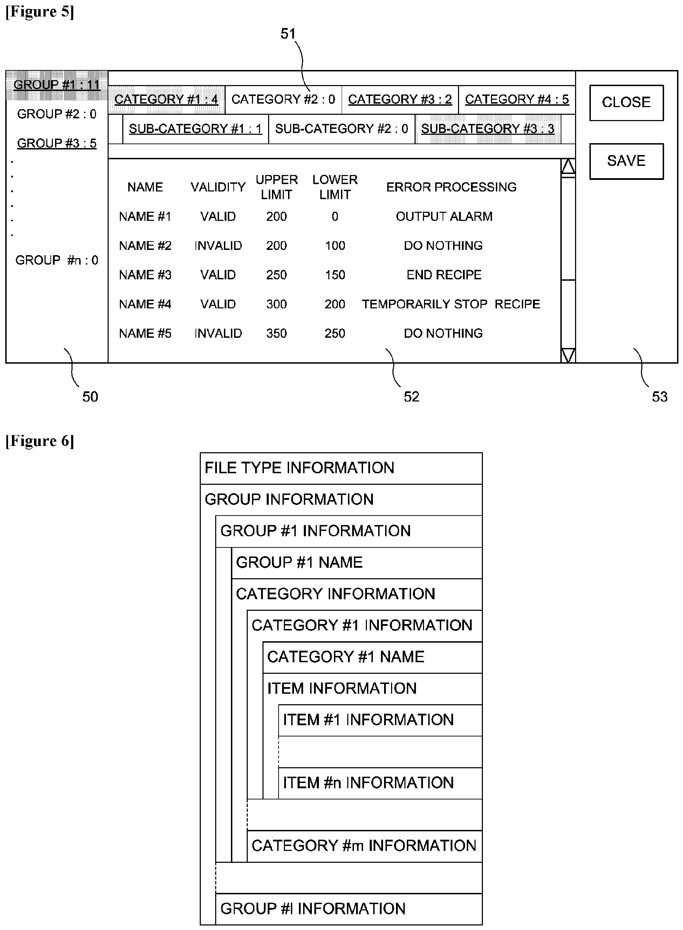

As shown in FIG. 6, the recipe file contains a plurality of groups, and each group contains the process conditions (of the substrate processing) constituted by the plurality of categories wherein the process conditions are classified into the plurality of categories. Further, the process conditions (of the substrate processing) contained in each group may correspond to a recipe prepared in advance for various types of the substrate processing.

The display 204 displays on the screen the validity information and the setting value for each item (which are contained in the plurality of categories of one of the groups) such that the validity information and the setting value can be edited. As shown in FIG. 5, the display 204 is provided with a group display area 50 on a left portion of the screen, a category selection area 51 at an upper central portion of the screen and a category editing area 52 at a lower central portion of the screen. For example, the display 204 reads the recipe file from the memory 104 in accordance with an instruction to display the recipe file by the operator, and displays a list of group names of the groups contained in the recipe file in the group display area 50. When an operation input to select a group name is provided from the manipulator 203, the display 204 displays category names of the categories contained in the group whose group name is selected in accordance with the operation input in the category selection area 51. Further, the display 204 displays names of the items contained in each category, the validity information and the setting value for each item in the category editing area 52. For example, the validity information and the setting value displayed in the category editing area 52 can be edited in accordance with an operation input from the manipulator 203. The category editing area 52 can be scrolled. Thus, items that cannot be displayed within a range of the category editing area 52 can be checked and edited by scrolling the category editing area 52.

Further, the display 204 is provided with a command selection area 53 on a right portion of the screen. For example, command buttons are displayed in the command selection area 53. In FIG. 5, for example, command buttons corresponding to a "Close" command and a "Save" command, respectively, are displayed. The "Close" command is a command to discard the edited contents and end an edit operation. The "Save" command is a command to end the edit operation and store an entirety of data including the validity information (which has been edited) and the setting value (which has been edited) in the memory 104 as the recipe file. Further, the display 204 may be configured to display appropriate command buttons related to appropriate functions.

For example, when a selection operation (operation input) to select a category name displayed in the category selection area 51 is performed through the manipulator 203, the display 204 displays the item contained in the category whose category name is selected in accordance with the selection operation, and the display 204 further displays the validity information and the setting value for each item in the category editing area 52. Further, for example, when a selection operation to select another category name is performed through the manipulator 203, the display 204 switches the screen to display the item contained in the another category whose category name is selected in accordance with the selection operation, and further to display the validity information and the setting value for each item in the category editing area 52.

In an example of the screen shown in FIG. 5, as the group names, "Group #1", "Group #2", "Group #3", ... "Group #n" are displayed in the group display area 50. Further, as the category names, "Category #1", "Category #2", "Category #3", and "Category #4" are displayed in an upper portion of the category selection area 51, and as sub-category names of sub-categories of the selected category, "Sub-category #1", "Sub-category #2" and "Sub-category #3" are displayed in a lower portion of the category selection area 51. For example, the selected category and the sub-categories thereof may be displayed in a recognizable manner such as a color inversion to clearly show that they are selected.

FIG. 5 is a diagram schematically illustrating a state in which "Category #1" is selected and the subcategories of "Category #1", that is, "Sub-category #1", "Sub-category #2" and "Sub-category #3" are displayed in the lower portion of the category selection area 51 (the selected category is indicated by hatching). Further, in the example of the screen shown in FIG. 5, a state in which "Sub-category #3" is selected from the sub-categories of "Category #1" is shown, and the item of "Sub-category #3" of "Category #1" is displayed in the category editing area 52. Further, in the example of the screen shown in FIG. 5, the item contained in "Sub-category #3" of "Category #1" selected in the category editing area 52 is displayed and the validity information and the setting value (upper limit value and lower limit value) for each item are displayed in the category editing area 52. When performing the substrate processing, specifically, the category names may be "temperature", "gas flow rate", "pressure" and the like, and for example, the subcategory names may be "main heater", "sub heater" and the like when the selected category name is "temperature".

Further, in the memory 104, the validity information and the setting value of the item (which has been edited) are stored as the recipe file.

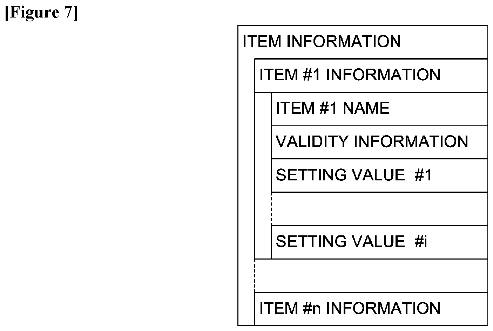

FIGS. 6 and 7 are diagrams schematically illustrating examples of a structure of the recipe file (that is, a file structure). As shown in FIG. 6, the recipe file is configured as a hierarchical structure. The recipe file is constituted by: group information that indicates top-level groups; category information that indicates a plurality of categories contained in each group; and item information that indicates a plurality of items contained in each category. In the example of FIG. 6, the recipe file contains information on "Group 1" to "Group I".

The group information contains a group name of each group and information on the "Category #1" to "Category #m" contained in each group, each piece of the category information on "Category #1" to "Category #m" contains a category name of each category and item information on "Item #1" to "Item #n" contained in each category. Further, as shown in FIG. 7, each piece of item information on "Item #1" to "Item #n" contains an item name of each item, the validity information of each item and "Setting value #1" to "Setting value #i" of each item. The validity information is stored for each item. In the example of FIG. 7, a plurality of setting values stored for each item. For example, two setting values such as an upper limit value and a lower limit value may be stored for each item. In the example of FIG. 5, the validity information for "Name #1", "Name #3" and "Name #4" is set to "valid", and the validity information for "Name #2" and "Name #5" is set to "invalid".

The recipe file further contains the process conditions for performing the substrate processing. In addition, the recipe file may further contain alarm conditions (which define upper and lower limit values) of the setting value for each item and a processing to be performed when the setting value for each item is higher than the upper limit value or the lower than the lower limit value. In FIG, 7, the example of storing the validity information and the setting value for each item is shown. However, for example, an alarm processing such as an error processing, an output processing of an alarm and an end processing (end of the recipe) of the substrate processing according to the recipe when the setting value for each item is higher than the upper limit value or lower than the lower limit value may also be stored (see FIG. 5).

The calculator 107 tallies the validity information recorded in the recipe file for each category (sub-category) and tallies the number of items contained in each category (sub-category) for which the validity information is set to "valid". Further, the calculator 107 tallies, for each group, the total number of items for which the validity information is set to "valid" for each category of each group as the number of items that are valid for the group.

The display 204 displays each category displayed in the category selection area 51 in a recognizable manner to clearly show whether the setting value of the item contained in the category is valid or invalid based on the validity information. That is, a case where the setting value of the item contained in the category is valid and a case where the setting value of the item contained in the category is invalid may be displayed in different manners. Specifically, for each category displayed in the category selection area 51, it is determined whether or not the valid item is contained in each category from the values tallied by the calculator 107 based on the validity information. For example, as shown in FIG. 5, when the valid item is contained in the items in the category, the category name is displayed underlined, and when no valid item is contained in the items in the category, the category name is displayed without being underlined. Alternatively, a color used for the category name may be changed depending on whether or not the valid item is contained in the items in the category, or the category name may be displayed in a flashing manner when the valid item is contained in items in the category. Further, as shown in FIG. 5, it is preferable to display the number of valid items in the category, which is tallied by the calculator 107, next to the category name. Such a display mode described above is merely an example, and the category name may be displayed in an appropriate format such that whether or not the valid item is contained in the items in the category can be distinguished.

Similar to the category, the display 204 displays the name of the sub-category in a recognizable manner to clearly show whether the setting value of the item contained in the sub-category is valid or invalid. Since a display mode of the name of the sub-category is substantially the same as that of the mane of the category, a detailed description thereof will be omitted.

Further, the display 204 displays each group in the group display area 50 to clearly show whether the setting value of the item contained in the plurality of categories contained in the group is valid or invalid based on the validity information. That is, in a case where the setting value of the item contained in the category contained in the group is valid and in a case where the setting value of the item contained in the category contained in the group is invalid, the group name in the group display area 50 may be displayed in different manners. Specifically, for each group displayed in the group display area 50, it is determined whether or not there is an item whose setting value is valid (that is, whether or not a valid item is present) in an entirety of categories contained in the group from the values tallied by the calculator 107 based on the validity information. For example, as shown in FIG. 5, when the valid item is contained in the items in the group, the group name is displayed underlined, and when no valid item is contained in the items in the group, the group name is displayed without being underlined. Alternatively, a color used for the group name may be changed depending on whether or not the valid item is contained in the items in the group, or the group name may be displayed in a flashing manner when the valid item is contained in the items in the group. Further, as shown in FIG. 5, it is preferable to display the number of valid items in the group, which is tallied by the calculator 107, next to the group name. Such a display mode described above is merely an example, and the group name may be displayed in an appropriate format such that whether or not the valid item is contained in the items in the group can be distinguished.

In the example of FIG. 5, the group display area 50 indicates that eleven items in "Group #1" are valid and five items in "Group #3" are valid. The group display area 50 further indicates that "Group #1" is selected, and the categories of "Group #1" are displayed in the category selection area 51. The category selection area 51 also indicates that four items in "Category #1" of "Group #1" are valid, two items in "Category #3" of "Group #1" are valid, and five items in "Category #4" of "Group #1" are valid. The category selection area 51 further indicates that "Category #1" is selected, and the sub-categories of "Category #1" are displayed in the lower portion of the category selection area 51. The category selection area 51 further indicates that one item in "Sub-category #1" of "Category #1" is valid, and three items in "Sub-category #3" of "Category #1" are valid. The category selection area 51 also indicates that "Sub-category #3" is selected, and the validity information and the setting value of the item in "Sub-category #3" of "Category #1" (which is selected) are displayed in the category editing area 52.

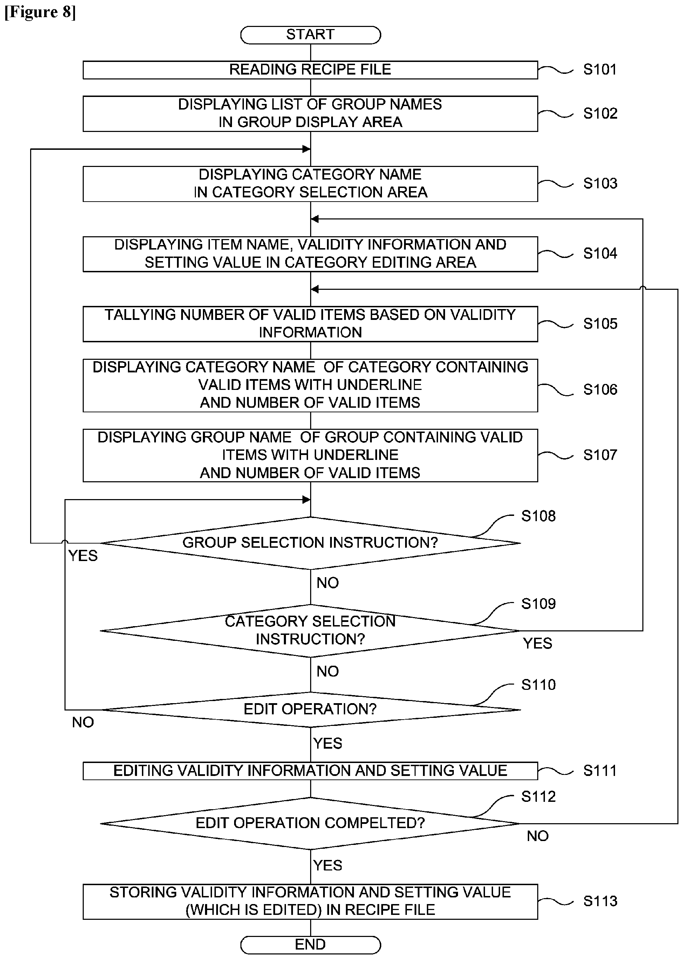

Subsequently, a process flow of the display processing apparatus will be described with reference to a flowchart shown in FIG. 8.

After the display processing apparatus 106 is started up, for example, when the edit operation on the recipe is selected by the manipulator 203, the display processing apparatus 106 reads out the recipe file stored in the memory 104 and expands the recipe file on the main memory 103 (step S101). Then, the group names contained in the recipe file are read out, and the display 204 displays a list of the group names in the group display area 50 of the screen (step S102). The display 204 further displays the category names and the sub-category names of the group selected as the default (for example, "Group #1") in the category selection area 51 (step S 103). The display 204 further displays a list of the validity information and the setting value for each item in "Sub-category #1" of "Category #1" in the category editing area 52 (step S104). Subsequently, the calculator 107 tallies the number of valid items for each group, for each category, and for each sub-category (step S105). In addition, the display 204 further displays the category names of the categories which contain the valid item therein and the sub-category names of the sub-categories which contain the valid item therein in the category selection area 51 with an underline, and the number of the valid items shown next to the category name and the sub-category name is changed to the number tallied by the calculator 107 (step S106). In the present embodiments, for the category names of the categories which do not contain the valid item therein, the underline is removed (that is, not displayed), the sub-category names of the sub-categories which do not contain the valid item therein are removed, and the number of items in the category names and in the sub-category names related thereto are hidden. Alternatively, the number of items in the category names and in the sub-category names which do not contain the valid item therein may be displayed as "0", for example, as long as they can be distinguished from the categories and subcategories which contain the valid item therein. In addition, the display 204 further displays the group names of the groups that contain the categories which contain the valid item therein in the group display area 50 with an underline, and the number of the valid items next to the group name is updated to the number newly tallied by the calculator 107 (step S107). In the present embodiments, the underline is removed for the group name of the group which does not contain the valid item therein. In addition, when no valid item is contained in the group, for example, "0" may be displayed as long as it can be distinguished from the group which contains the valid item therein.

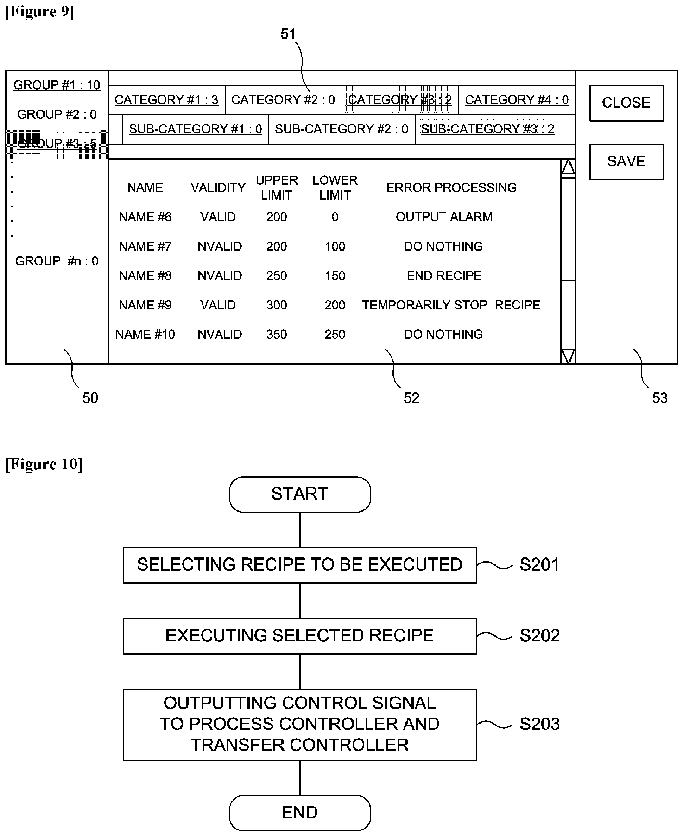

Subsequently, it is determined whether a selection instruction (group selection instruction) (which is an operation input) to select a group from the list of groups displayed in the group display area 50 has been issued from the manipulator 203 (step S108). To check the validity information (which has been edited) and the setting value (which has been edited), the operator selects the group to be checked from the groups displayed with the underline in FIG. 5. For example, when the group selection instruction to select "Group #3" has been issued from the manipulator 203 ("YES" in the step S108), the display 204 switches the category selection area 51 to display the categories of "Group #3" (step S103). Further, the display 204 displays the item and setting value of the categories contained in "Group #3" in the category editing area 52 (step S104). FIG. 9 shows an example of the screen when "Group #3" is selected.

Further, when the operation input from the manipulator 203 is not the group selection instruction to select the group ("NO" in the step S108), it is determined whether or not a category selection instruction has been issued (step S109). Since the operator wants to display and check the item that is valid among the plurality of items, for example, the operator selects "Category #3" whose category name is underlined among the category names displayed in the upper portion of the category selection area 51 (see FIG. 9). When "Category #3" is selected, the sub-categories displayed in the lower portion of the category selection area 51 are switched to the sub-category names of "Category #3". Therefore, by selecting "Sub-category #3" whose sub-category name is underlined among the sub-categories displayed in the lower portion of the category selection area 51 ("YES" in the step S109), the validity information and the setting value of the item contained in "Sub-category #3" of the "Category #3"selected as described above are displayed in the category editing area 52 (step S104). Whenever the group selection instruction or the category selection instruction is issued, the steps S104 to S109 are repeatedly performed.

As described above, by underlining the group name, the category name or the sub-category name which contains therein the item with the valid setting value and selecting the group name, the category name or the sub-category name displayed underlined, it is possible to display a list of items which contain therein the valid setting values in the category editing area 52. Thereby, it is possible to quickly check the setting value which is valid.

Subsequently, the validity information of the items displayed in the category editing area 52 is edited. It is determined whether an edit operation (operation input) has been issued from the manipulator 203 to edit the validity information displayed in the category editing area 52 (step S110). It waits for an input until the edit operation is issued ("NO" in the step S110). When the edit operation is issued ("YES" in the step S110), the validity information is changed in accordance with the edit operation (step S111). Alternatively, the setting value or the contents of the error processing may also be edited. Further, when the group selection instruction to select the group or the category selection instruction to select the category is issued while waiting for the input of the edit operation, the display of the category selection area 51 and the category editing area 52 is switched as described above.

The processing of the steps S103 to S111 is repeatedly performed unless the "Save" button in the command selection area 53 on the screen is pressed through the manipulator 203 ("NO" in a step S112). When the "Save" button in the command selection area 53 on the screen is pressed through the manipulator 203 ("YES" in a step S112), it is determined that the edit operation is completed, and the recipe file including the validity information and the setting value is stored in the memory 104 (step S113).

As described above in detail, in the present embodiments, in order to check whether one of the items contained in each of the plurality of categories contains the setting value which is valid, the categories are displayed in the category selection area 51 on the screen. Thus, it is possible to select the category that contains the item which is valid, and thereby, it is possible to improve a work efficiency of the operator and to prevent an erroneous editing. Further, it also possible to easily check under what conditions the item which is valid will generate an alarm.

Furthermore, when applied to the substrate processing apparatus, by dividing the categories into, for example, "temperature", "gas flow rate", "pressure" and the like, it is possible to display related items without displaying unrelated items. Thereby, it is possible to prevent incorrect settings by the operator.

Subsequently, a process of executing the recipe and performing the substrate processing after saving the recipe file will be described with reference to a flowchart shown in FIG. 10.

First, one of the groups is selected from the recipe files (which are stored in advance) as the recipe to be executed for the substrate processing (step S201). When the recipe execution program is started up, the controller 101 shown in FIG. 3 functions as a control execution structure. In addition, the setting value and the validity information of each item contained in the category of the group stored in the recipe file are loaded onto the main memory 103, and the control execution structure executes each process of the substrate processing in accordance with the recipe (step S202), and outputs a control signal from the control apparatus 100 of the substrate processing apparatus 1 to each controller (or driver) of the process controller 205 and the transfer controller 206 (step S203). The transfer controller 206 controls the rotation driver 210, the elevation driver 211 and the transfer driver 212 to transfer the wafer 18 to the standby space 27, the process furnace 28 or the process chamber 29. On the other hand, the process controller 205 controls the temperature controller 207, the gas flow rate controller 208 and the pressure controller 209 to control the temperature, the flow rate of the process gas and the pressure. Further, when the temperature controller 207, the gas flow rate controller 208 or the pressure controller 209 detects that the temperature, the gas flow rate or the pressure is higher than the upper limit value or lower than the lower limit value (wherein the upper limit value and the lower limit value indicate a range within which the validity information for each item specified in the recipe is valid), an alarm processing is executed. When an entirety of the steps are completed, the substrate processing is completed.

### <Other Embodiments of Present Disclosure>

The configurations of the display processing apparatus and the substrate processing apparatus described in the embodiments mentioned above are merely examples, and may be modified in accordance with circumstances without departing from the scope of the technique of the present disclosure.

Further, the process flow described in the embodiments mentioned above is merely an example, and redundant steps may be deleted, new steps may be added or process procedures may be changed, without departing from the scope of the technique of the present disclosure.

For example, the embodiments mentioned above are described by way of an example in which the processing according to the embodiments is implemented by a software configuration that uses the computer to execute the program. However, the technique of the present disclosure is not limited thereto. For example, the technique of the present disclosure may also be applied to a hardware configuration capable of performing the processing, or may also be applied to a combination of hardware and software configuration capable of performing the processing.

Further, the substrate processing apparatus according to the embodiments of the present disclosure may include not only a substrate manufacturing apparatus capable of manufacturing a semiconductor device but also an apparatus capable of processing a glass substrate such as an LCD (Liquid Crystal Display) device. The contents of the substrate processing may include not only a film forming process of forming a film such as a CVD (Chemical Vapor Deposition) film, a PVD (Physical Vapor Deposition) film, an epitaxial growth film, an oxide film, a nitride film and a metal-containing film, but also a process such as an annealing process, an oxidation process, a diffusion process, an etching process, an exposure process, a photolithography process, a coating process, a molding process, a developing process, a dicing process, a wire bonding process and an inspection process.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates at a time is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The invention may be summarized as follows: There is provided a technique capable of easily identifying information related to a valid setting item used in a substrate processing apparatus when performing a file editing in a display processing apparatus. There is provided a technique that includes: a memory configured to store a file containing a plurality of items for each of a plurality of categories, setting values for each of the plurality of items and validity information indicating whether the setting values for each of the plurality of items are valid, wherein process conditions for a substrate are classified into the plurality of categories; a display configured to display the validity information and the setting values for each of the plurality of items classified for each of the plurality of categories on a screen for each of the categories; and a manipulator configured to perform an edit operation on the validity information displayed on the screen.

The process procedures and the process conditions of each process using the substrate processing apparatuses exemplified above may be substantially the same as those of the embodiments or modified examples described above. Even in such a case, it is possible to obtain substantially the same effects as in the embodiments or the modified examples described above.

### [Description of Reference Numerals]

| | | | |
|---|---|---|---|
| 104 | Memory | 203 | Manipulator |
| 204 | Display | | |

## Claims

1. A display processing apparatus comprising:
a memory configured to store a file containing a plurality of items for each of a plurality of categories, setting values for each of the plurality of items and validity information indicating whether the setting values for each of the plurality of items are valid, wherein process conditions for a substrate are classified into the plurality of categories;
a display configured to display the validity information and the setting values for each of the plurality of items classified for each of the plurality of categories on a screen for each of the categories; and
a manipulator configured to perform an edit operation on the validity information displayed on the screen.

2. The display processing apparatus of claim 1, wherein the file contains a plurality of groups, and each of the plurality of groups contains the process conditions for the substrate constituted by the plurality of categories, and
wherein the display is further configured to editably display the validity information of the plurality of items contained in the plurality of categories contained in a group among the plurality of groups on the screen for each of the plurality of categories.

3. The display processing apparatus of claim 2, wherein the display is further configured to provide a group display area in which a list of the plurality of groups is displayed on the screen, and further configured to recognizably display, for each of the plurality of groups displayed in the group display area, whether or not a valid item is contained in the plurality of items contained in the plurality of categories contained in the group based on the validity information.

4. The display processing apparatus of any one or more of claims 1 to 3, wherein the display is further configured to provide a category selection area configured to display a category among the plurality of categories in a selectable manner, and further configured to recognizably display, for each of the plurality of categories displayed in the category selection area, whether or not a valid item is contained in the plurality of items contained in the category based on the validity information.

5. The display processing apparatus of claim 4, wherein, in accordance with an operation input from the manipulator to select the category among the plurality of categories displayed in the category selection area, the display is further configured to editably display the validity information of the plurality of items contained in the category selected in accordance with the operation input.

6. The display processing apparatus of claim 4 and/or 5, wherein the display is further configured to display, for each of the plurality of categories displayed in the category selection area, the number of valid items among the plurality of items contained in the category based on the validity information.

7. The display processing apparatus of any one or more of claims 3 to 6, wherein the display is further configured to display, for each of the plurality of groups displayed in the group display area, the number of valid items among the plurality of items contained in the category contained in the group based on the validity information.

8. The display processing apparatus of any one or more of claims 4 to 7, wherein the display is further configured such that, when the valid item is contained in the plurality of items contained in the category among the plurality of categories displayed in the category selection area and no valid item is contained in the plurality of items contained in another category among the plurality of categories displayed in the category selection area, a category name of the category is displayed in the category selection area in a display mode different from a display mode of a category name of the another category.

9. The display processing apparatus of any one or more of claims 3 to 8, wherein the display is further configured such that, when the valid item is contained in the plurality of items contained in the category of the group among the plurality of groups displayed in the group display area and no valid item is contained in the plurality of items contained in another group among the plurality of groups displayed in the group display area, a group name of the group is displayed in the group display area in a display mode different from a display mode of a group name of the another group.

10. The display processing apparatus of any one or more of claims 1 to 9, wherein the file contains process conditions for processing the substrate, and
the display is further configured to display:
alarm conditions defining upper and lower limit values of the setting values for each of the plurality of items; and
an alarm to be performed when each of the setting values for each of the plurality of items is higher than the upper limit value or lower than the lower limit value.

11. A substrate processing apparatus comprising:
the display processing apparatus of any one or more of claims 1 to 10; and
a controller configured to be capable of controlling a processing of the substrate using the file.

12. A display method comprising
(a) classifying process conditions for a substrate into a plurality of categories, and storing a file containing a plurality of items for each of the plurality of categories, setting values for each of the plurality of items and validity information indicating whether the setting values for each of the plurality of items are valid;
(b) displaying the validity information classified for each of the plurality of categories on a screen for each of the plurality of categories; and
(c) performing an edit operation on the validity information displayed on the screen.

13. A substrate processing method comprising
processing the substrate based on the file of the display method of claim 12.

14. A method of manufacturing a semiconductor device, comprising processing the substrate based on the file of the display method of claim 12.

15. A program that causes a substrate processing apparatus, by a computer, to perform:
(a) classifying process conditions for a substrate into a plurality of categories, and storing a file containing a plurality of items for each of the plurality of categories, setting values for each of the plurality of items and validity information indicating whether the setting values for each of the plurality of items are valid;
(b) displaying the validity information classified for each of the plurality of categories on a screen for each of the plurality of categories; and
(c) performing an edit operation on the validity information displayed on the screen.
